(19) **Europäisches Patentamt**
**European Patent Office**
**Office européen des brevets**

(11) **EP 4 150 667 B1**

(12) **EUROPÄISCHE PATENTSCHRIFT**

(45) Veröffentlichungstag und Bekanntmachung des Hinweises auf die Patenterteilung:
**22.05.2024 Patentblatt 2024/21**

(21) Anmeldenummer: **21746402.3**

(22) Anmeldetag: **14.07.2021**

(51) Internationale Patentklassifikation (IPC):
**H01L 23/367** (2006.01)

(52) Gemeinsame Patentklassifikation (CPC):
(C-Sets verfügbar)
**H01L 23/367;** H01L 2224/2908; H01L 2224/2919; H01L 2224/32013; H01L 2224/32245; H01L 2224/83101; H01L 2224/83385; H01L 2924/10155 (Forts.)

(86) Internationale Anmeldenummer:
**PCT/EP2021/069637**

(87) Internationale Veröffentlichungsnummer:
**WO 2022/028835 (10.02.2022 Gazette 2022/06)**

(54) **KONTAKTSYSTEM MIT ZUVERLÄSSIGER ISOLIERUNG**

CONTACT SYSTEM WITH RELIABLE INSULATION

SYSTÈME DE CONTACT À ISOLATION FIABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.08.2020 EP 20189973**

(43) Veröffentlichungstag der Anmeldung:
**22.03.2023 Patentblatt 2023/12**

(73) Patentinhaber: **Siemens Aktiengesellschaft**
**80333 München (DE)**

(72) Erfinder:
• **MÜLLER, Volker**
**90459 Nürnberg (DE)**

• **NEUGEBAUER, Stephan**
**91058 Erlangen (DE)**

(74) Vertreter: **Siemens Patent Attorneys**
**Postfach 22 16 34**
**80506 München (DE)**

(56) Entgegenhaltungen:
**DE-T5-112012 005 920    US-A1- 2016 276 245**
**US-A1- 2019 027 421**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**(Forts. nächste Seite)**

(52) Gemeinsame Patentklassifikation (CPC): (Forts.)

C-Sets
H01L 2224/2908, H01L 2924/00014;
H01L 2224/2919, H01L 2924/00014

## Beschreibung

Die Erfindung betrifft ein Kontaktsystem aufweisend einen Kühlkörper und einen Auflagekörper. Die Erfindung betrifft weiter ein Verfahren zur Herstellung eines derartigen Kontaktsystems.

Beim Aufbau elektrischer Geräte oder Komponenten stellt sich oftmals die Aufgabe, zwei Körper, beispielsweise einen Kühlkörper und einen Auflagekörper, mechanisch und teilweise auch thermisch miteinander zu verbinden. Um diese Verbindung, auch als Kontaktierung bezeichnet, elektrisch isolierend auszuführen, können die zwei unterschiedliches elektrisches Potenzial führende Bauteile durch eine Isolierschicht mit elektrisch isolierender Wirkung getrennt werden.

US 2019/027421 A1 offenbart ein Wärmeableitungssystem mit einem Kühlkörper.

Es hat sich gezeigt, dass diese Isolierschicht bei der Kontaktierung oder im Betrieb des Gerätes bzw. der Komponente, Schädigungen erfährt und dann, schlagartig oder schleichend über die Zeit, die elektrisch isolierende Wirkung dadurch verliert.

Der Erfindung liegt die Aufgabe zugrunde, ein Kontaktsystem für eine Kontaktierung, insbesondere eine elektrisch isolierende Kontaktierung, zu verbessern.

Diese Aufgabe wird durch ein Kontaktsystem gemäß dem unabhängigen Anspruch 1 und das entsprechende Verfahren zur Herstellung des Kontaktsystems gemäß unabhängigen Anspruch 11 gelöst.

Weitere vorteilhafte Ausgestaltungen der Erfindung sind in den abhängigen Ansprüchen angegeben.

Der Erfindung liegt unter anderem die Erkenntnis zugrunde, dass sich die elektrisch isolierende Wirkung deutlich insbesondere hinsichtlich ihrer Zuverlässigkeit und Langlebigkeit verbessern lässt, wenn an dem Kühlkörper an der für die Kontaktierung mit dem Auflagekörper vorgesehenen Stelle, eine Ausnehmung vorhanden ist. Es hat sich gezeigt, dass beispielsweise durch Bauteilfehler, wie beispielsweise durch Schneidprozesse entstandene Grate, die Gefahr der Beschädigung der Isolierschicht entsteht. Die Gefahr wächst mit der Kraft, mit der der Auflagekörper während der Montage und/oder dauerhaft auf den Kühlkörper gedrückt wird. Meist ist die Isolierschicht dünn und/oder weich, so dass ein Grat zu einer Veränderung und/oder Beschädigung der Isolierschicht führen kann. Dabei kann die elektrisch isolierende Wirkung schlagartig verloren gehen oder auch über die Zeit abnehmen.

Diese Isolierschicht mit elektrisch isolierender Wirkung stellt sicher, dass auch bei unterschiedlichen elektrischen Potenzialen von Kühlkörper und Auflagekörper kein elektrischer Strom fließt.

Auch für den Fall, dass der Auflagekörper direkt auf dem Kühlkörper angeordnet ist, also ohne dazwischenliegende Isolierschicht, auch als isolierschichtfrei bezeichnet, bietet die Ausnehmung Vorteile. Aufgrund der vorhandenen mechanischen Fehler an der Oberfläche wie beispielsweise Grate liegen die beiden Körper, Kühlkörper und Auflagekörper nicht plan aneinander an. Das kann das Betriebsverhalten negativ beeinflussen. Beispielsweise verschlechtert sich ein Wärmeübergang von einer elektrischen oder elektronischen Komponente zu einem Kühlkörper dadurch. Dadurch kann unter Umständen die Entwärmung nicht mehr sichergestellt werden. Eine Verkürzung der Lebensdauer oder Ausfall der Komponente ist die Folge. Mit anderen Worten kann durch die Ausnehmung des Kühlkörpers sichergestellt werden, dass Kühlkörper und Auflagekörper an der Kontaktfläche außerhalb der Ausnehmung plan aneinander anliegen und ein guter Wärmeübergang erzielt wird.

Durch die Ausnehmung an der ersten Oberfläche des Kühlkörpers kann die negative Wirkung der Grate weitestgehend vermieden werden. Durch die Ausnehmungen führen die Überhöhungen aufgrund der Grate am Rand der Kontaktfläche nicht mehr zu einem wenn auch geringen Abstand zwischen Kühlkörper und Auflagekörper. Die Unebenheiten werden durch die Ausnehmungen aufgenommen, der übrige plane Teil der Kontaktfläche des Auflagekörpers liegt dann plan am Kühlkörper an. Dadurch entsteht beispielsweise auch ein besonders guter Wärmeübergang zwischen Kühlkörper und Auflagekörper.

Die schädigende Wirkung der Grate auf eine Isolierschicht kann ebenfalls durch die Ausnehmungen beseitigt oder zumindest deutlich verringert werden, wenn an der betreffenden Stelle der Kontaktfläche, also insbesondere am Rand der Kontaktfläche des Auflagekörpers, keine Gegenkraft durch den Kühlkörper entsteht. Dann wirkt auch keine Kraft oder nur eine geringe Kraft auf die dazwischenliegende Isolierschicht. Dies wird durch die Ausnehmung bewirkt. Vorteilhafterweise ist die Ausnehmung derart an der ersten Oberfläche angeordnet, dass sie sich entlang des Randes der Kontaktfläche des Auflagekörpers erstreckt. In diesem Fall wird zuverlässig verhindert, dass ein am Rand der Kontaktfläche des Auflagekörpers vorhandener Grat die Isolierschicht beschädigt und/oder zerstört.

Dabei kann es vorteilhaft sein, nur eine Ausnehmung an einer Stelle vorzunehmen, der nur einem Teil des Randes der Kontaktfläche des Auflagekörpers entspricht. Für den Fall, dass beispielsweise nur an wenigen Stellen des Auflagekörpers die Gefahr von mechanischen Störungen, wie beispielsweise ein Grat, vorhanden ist, kann sich die Ausnehmung auf den Bereich beschränken, an dem der für die Kontaktierung vorgesehene Rand der Kontaktfläche des Auflagekörpers eine erhöhte Gefahr für das Vorhandenseins eines Grates aufweist.

Es hat sich gezeigt, dass die Gefahr der Beschädigung der Isolierschicht größer ist, je größer die Abmessungen des Auflagekörpers, insbesondere je größer die Abmessungen der Kontaktfläche des Auflagekörpers, sind. Insbesondere auch eine größere Randlänge erhöht das Risiko einer Beschädigung.

Durch die Ausnehmungen auf dem Kühlkörper ist es möglich, die Anforderungen, beispielsweise in Form einer Bauteilspezifikation, an eine Gratfreiheit zu reduzieren. Damit können die Fertigungskosten des betreffenden Bauteils reduziert werden. Da eine Gratfreiheit nicht immer gewährleistet werden kann, reduziert sich der Ausschuss bzw. der Aufwand an Nacharbeit, insbesondere von manueller Nacharbeit, für die Sicherstellung der erforderlichen Qualität. Ebenso können Qualitätstests im Rahmen der Montage vereinfacht werden.

Darüber hinaus ergibt sich der Vorteil, dass die Isolierschicht dünner ausgeführt sein kann. Durch die Ausnehmungen und damit die geringere oder nicht mehr vorhandene Kraft an den Graten der Kontaktfläche ist die Gefahr der Beschädigung der Isolierschicht so gering, dass auf eine vorsorglich zur Sicherstellung der elektrischen Isolationswirkung ausgeführten dickeren Isolierschicht verzichtet werden kann. Die Dicke der Isolierschicht kann sich dann vorteilhafterweise ausschließlich nach der elektrischen Isolationsfähigkeit richten. Damit kann die Isolierschicht besonders dünn ausgelegt werden. Diese ist kostengünstig und besonders einfach zu verarbeiten. Gleichzeitig wird ein guter Wärmeübergang sichergestellt.

Die Isolierschicht kann die Ausnehmung teilweise überdecken. Dadurch wird das Material für die Isolierschicht sparsam eingesetzt. Alternativ ist es auch vorteilhaft, wenn die Isolierschicht die Ausnehmung vollständig bedeckt. Dadurch wird beispielsweise zuverlässig die Ablagerung von Verschmutzung in der Ausnehmung verhindert.

Dabei ist die erste Oberfläche im Wesentlichen als eine ebene Fläche ausgeführt. Im Wesentlichen bedeutet, dass ein Großteil der ersten Oberfläche, beispielsweise mehr als 80%, als ebene Fläche ausgeführt ist. Neben der ebenen Fläche können Anteile auch von der ebenen Oberfläche abweichen. Zu diesen Anteilen gehören beispielsweise die Ausnehmung, Vorrichtungen zur Befestigung von Kühlkörper und Auflagekörper, wie Gewindestangen oder Löcher mit oder ohne Gewinde, sowie Montagevorrichtungen, Griffe bzw. Griffmulden zum Halten oder Transportieren des Kühlkörpers. Ein Kühlkörper Kühlkörperkann darüber hinaus mehrere ebene Flächen aufweisen, an der zu kühlende Elemente angebracht werden können. So kann ein Kühlkörper beispielsweise Z-förmig ausgebildet sein und mehrere Teilplatten aufweisen, die miteinander beispielsweise verlötet oder verschweißt sind.

Zumindest im Bereich der vorgesehenen Kontaktfläche mit dem Auflagekörper ist es vorteilhaft, wenn dieser Teil der ersten Oberfläche plan ist. Dadurch kann eine gute anliegende Verbindung erzielt werden, die neben einer hohen mechanischen Stabilität auch beispielsweise einen guten Wärmeübergang sicherstellt. Darüber hinaus kann auch zwischen Kühlkörper und Auflagekörper eine Isolierschicht, insbesondere eine Isolierschicht zur elektrischen Isolation, angeordnet werden. Diese stellt sicher, dass auch bei unterschiedlichen elektrischen Potenzialen von Kühlkörper und Auflagekörper unerwünschte elektrische Ströme zuverlässig verhindert werden. Durch die ebene Ausgestaltung der ersten Oberfläche des Kühlkörpers und der Kontaktfläche des Auflagekörpers wird sichergestellt, dass die Isolierschicht, insbesondere eine Isolierfolie, keine Kräfte oder nur geringe Kräfte erfährt, die zum Reißen der Schicht bzw. Folie führen können. Durch die ebene Oberfläche ergibt sich keine oder nur eine geringe Anforderung an die Reißfestigkeit der Folie bzw. der Isolierschicht.

Bei einer vorteilhaften Ausgestaltung der Erfindung ist die Ausnehmung derart ausgebildet, dass die Ausnehmung sich vollständig entlang des Bereiches erstreckt, der für die Kontaktierung mit dem Rand der Kontaktfläche des Auflagekörper vorgesehen ist. Der gesamte Rand der Kontaktfläche bildet oftmals das größte Risikopotential für die Entstehung von Kanten und Grate, die ein planes Aufliegen verhindern bzw. eine Beschädigung der Isolierschicht verursachen. Wenn daher der gesamte Rand der Kontaktfläche bei der Kontaktierung des Auflagekörpers mit dem Kühlkörper genau auf diese Ausnehmung trifft, liegt der Auflagekörper plan auf dem Kühlkörper auf. Falls eine Isolierschicht zwischen Auflagekörper und Kühlkörper vorhanden ist, erfährt diese aufgrund der Ausnehmung keine oder nur eine geringe mechanische Belastung. Daher ist es vorteilhaft, dass sich die Ausnehmung entlang des gesamten Rands der Kontaktfläche erstreckt.

Mit dieser Anordnung kann ein gleichmäßiger Druck über den Großteil der Kontaktfläche zwischen Kühlkörper und Auflagekörper sichergestellt werden. Dies führt beispielsweise bei einer direkten Kontaktierung unter anderem zu einem guten Wärmeübergang oder bei einer dazwischenliegenden Isolierschicht zu einer gleichmäßigen und moderaten Belastung der Isolierschicht, die zuverlässig und dauerhaft die Isolierschicht vor Beschädigung bewahrt.

Bei einer weiteren vorteilhaften Ausgestaltung der Erfindung weist der Kühlkörper eine Vielzahl von geschlossenen Bahnen von Ausnehmungen auf. Durch die Vielzahl der geschlossenen Bahnen ist es möglich, entweder mehrere Auflagekörper mit dem Kühlkörper zu verbinden oder unterschiedlich ausgestaltete Auflagekörper mit dem Kühlkörper zu verbinden. Der Kühlkörper kann dann besonders flexibel ausgestaltet sein und eignet sich sowohl zur Kühlung mehrerer Komponenten als auch zur Aufnahme unterschiedlich ausgestalteter Auflagekörper und ist somit besonders flexibel einsetzbar.

Bei einer weiteren vorteilhaften Ausgestaltung der Erfindung ist der Querschnitt der Ausnehmung rechteckförmig oder gerundet ausgeführt. Die Ausnehmung kann besonders einfach rechteckförmig in die erste Oberfläche des Kühlkörpers eingebracht werden. Das ist mit Standardwerkzeugen auf einfache Weise möglich. Eine gerundete Querschnittsfläche kann ebenfalls einfach mit Standardwerkzeugen eingebracht werden. Da bei der gerundeten Querschnittsflächen keine Kanten vorhanden sind, wird dadurch gleichzeitig die Verletzungsgefahr bei der Montage reduziert. Ebenfalls besteht bei der Ausgestaltung der Ausnehmung mit einem gerundeten Querschnitt nur eine geringe Gefahr, die Isolierschicht zu beschädigen, insbesondere wenn die Isolierschicht als Folie ausgebildet ist.

Bei einer weiteren vorteilhaften Ausgestaltung der Erfindung ist der Übergang zwischen der Ausnehmung und dem ebenen Teil der ersten Oberfläche gebrochen ausgebildet. Durch die gebrochene Ausbildung kann sichergestellt werden, dass auch der Kühlkörper, insbesondere an seiner ersten Oberfläche, keinen Grat aufweist. Mit anderen Worten ist die erste Oberfläche des Kühlkörpers gratfrei ausgebildet. Dies stellt sicher, dass Auflagekörper und Kühlkörper plan aneinander anliegen und auch eine möglicherweise dazwischenliegende Isolierschicht keine hohe Belastung bzw. hohen Druck erfährt. Somit kann die Gefahr der Beschädigung noch weiter reduziert werden und die Langlebigkeit der isolierenden Wirkung erhöht werden, wenn die Kanten der Ausnehmung gebrochen ausgeführt sind.

Bei einer weiteren vorteilhaften Ausgestaltung der Erfindung ist zwischen dem Kühlkörper und dem Auflagekörper eine elektrisch isolierende Schicht angeordnet. Das plane und ebene Anliegen von Kühlkörper und Auflagekörper bringt eine äußerst geringe Belastung für eine zwischen dem Kühlkörper und dem Auflagekörper angeordneten Isolierschicht mit sich. Es besteht keine oder nur sehr geringe Gefahr des Reißens oder der Durchdringung der Isolierschicht mit sich. Ein Reißen oder Durchdringen hätte den Verlust der isolierenden Wirkung, insbesondere einer elektrisch isolierenden Wirkung, zur Folge. Die Isolierschicht kann dann besonders dünn ausgebildet sein. Gleichzeitig kann sie auch noch einen Teil der Ausnehmung oder die gesamte Ausnehmung überdecken, so dass eine ebene Oberfläche entsteht, die frei von Dreck- und/oder Staubablagerungen ist.

Die beschriebene Ausgestaltung bewährt sich besonders bei Verwendung sehr weicher oder dünner Isolierungen und sehr dicker Auflagekörper, sowie bei aufgebrachter Kraft des Auflagekörpers auf den Kühlkörper.

Vorteilhaft ist, wenn sichergestellt werden kann, dass Grund- und Auflagekörper sowie die Isolierung gegeneinander nicht beweglich sind. Dann ist die Belastung der Isolierschicht besonders klein und eine Beschädigung kann auch bei dünner Isolierschicht zumindest nahezu ausgeschlossen werden.

Bei einer weiteren vorteilhaften Ausgestaltung der Erfindung ist die elektrisch isolierende Schicht wärmeleitfähig. Ein besonderer Vorteil der Anordnung liegt darin, dass die Isolierschicht besonders dünn ausgebildet sein kann. Damit eignet sie sich auch im Besonderen, um zwei Körper miteinander zu verbinden, zwischen denen ein Wärmeaustauch erfolgen soll. Ein Beispiel für eine derartige Anwendung ist ein elektrisches oder elektronisches Bauteil als Auflagekörper auf dem Kühlkörper. Zur elektrischen Isolierung ist oftmals zwischen Bauteil und Kühlkörper eine wärmeleitende Isolierschicht mit elektrisch isolierender Wirkung angeordnet.

Zwar besitzt jeder Stoff eine wenn auch noch so geringe Wärmeleitfähigkeit. An dieser Stelle ist mit wärmeleitfähig eine Wärmeleitfähigkeit von mehr als

$$\lambda = 0{,}1\,\frac{W}{m \cdot K}$$

zu verstehen. Es sind elektrisch isolierende und robuste Materialien für die Isolierschicht verfügbar, die eine entsprechende Wärmeleitfähigkeit aufweisen. Darüber hinaus können für gut wärmeleitende Anforderungen Wärmeleitpads mit einer Wärmeleitfähig-

$$\lambda = 10\,\frac{W}{m \cdot K}$$

keit von mehr als eingesetzt werden. Gerade diese sind in ihrer Wärmeleitfähigkeit optimiert und entsprechend empfindlich gegenüber mechanischen Beschädigungen. Somit eignet sich die vorgeschlagene Anordnung insbesondere für eine Isolierschicht mit einer

$$\lambda = 10\,\frac{W}{m \cdot K}$$

Wärmeleitfähigkeit von mehr als .

Bei einer weiteren vorteilhaften Ausgestaltung der Erfindung wird die elektrisch isolierende Schicht durch eine Folie gebildet. Eine Folie ist besonders einfach in der Produktion einsetzbar und zu verarbeiten. Aufgerollt auf einer Rolle kann im Produktionsprozess die erforderliche Menge einfach zur Verfügung gestellt und verarbeitet werden. Der Nachteil der Gefahr des Reißens der Folie wird durch die Ausnehmung des Kühlkörpers zuverlässig vermieden. Somit ist der Einsatz der Folie als Isolierschicht besonders vorteilhaft. Darüber hinaus lassen sich mit einer Folie insbesondere auch besonders hohe Potenzialunterschiede mit nur einer geringen Foliendicke gegeneinander elektrisch isolieren. Darüber hinaus ist der Einsatz einer kleberbeschichteten Folie besonders vorteilhaft. Auch diese ist dünn und weist daher eine besonders gute Wärmeleitfähigkeit auf. Darüber hinaus wird eine Bewegung der Folie gegenüber des Kühlkörpers und/oder des Auflagekörpers zuverlässig vermieden. Dies stellt einen dauerhaft guten Wärmeübergang sowie eine dauerhaft gute elektrische Isolation sicher.

Bei einer weiteren vorteilhaften Ausgestaltung der Erfindung bedeckt die isolierende Schicht die Ausnehmung derart bedeckt, dass sich aus Ausnehmung und isolierender Schicht ein geschlossener Kanal ergibt. Durch die Abdeckung der Ausnehmung ist die Gefahr der Verschmutzung der Ausnehmung reduziert. Das Kontaktieren erfordert oftmals eine elektrisch isolierende Eigenschaft zwischen Kühlkörper und Auflagekörper. Durch Verschmutzung gerade im Bereich der Ausnehmung können Kriechstrecken entstehen, welche die elektrische Isolationsfähigkeit herabsetzen. Anders ausgedrückt, kann durch das Vermeiden der Verschmutzung die elektrische Isolation dauerhaft sichergestellt werden. Damit weist eine entsprechende Anordnung eine hohe Lebensdauer und Zuverlässigkeit auf.

Bei einer weiteren vorteilhaften Ausgestaltung der Erfindung ist in der Ausnehmung ein gelartiges Material angeordnet. Bei dem gelartigen Material kann es sich beispielsweise um eine gelartige Flüssigkeit handeln. Dabei kann es sich beispielsweise um eine Flüssigkeit, insbesondere eine wärmeleitfähige Flüssigkeit, handeln, die eine höhere Viskosität als Wasser aufweist. Durch den geschlossenen Kanal wird diese Flüssigkeit in der Ausnehmung gehalten und kann des Wärmeverhalten, d.h. den Wärmetransport zum Kühlkörper verbessern. Alternativ kann auch ein formveränderliches Material wie beispielsweise Gummi in die Ausnehmung eingebracht werden. Damit liegt insbesondere eine Folie als wärmeleitende Schicht an und die Gefahr des Reißens wird deutlich reduziert.

Bei einer weiteren vorteilhaften Ausgestaltung der Erfindung wird der Auflagekörper durch eine Stromschiene gebildet. Stromschienen werden oftmals aus Kupfer gebildet. Dieses wird zu Stromschienen geformt, meistens durch einen Schneidprozess, der am Rand der Stromschiene einen Grad entstehen lässt. Dieser kann bei einer Kontaktierung mittels einer isolierenden Schicht wie beispielsweise einer Folie diese Folie bzw. diese Schicht beschädigen. Daher eignet sich der vorgeschlagene Kühlkörper im besonderen Maße für die Kontaktieren einer Stromschiene mit einem Kühlkörper, da sich so auch bei nicht nachbehandelten Stromschienen sich diese zuverlässig und sicher mit dem Kühlkörper verbinden lassen.

Bei einer weiteren vorteilhaften Ausgestaltung der Erfindung weist das Kontaktsystem eine Vielzahl von Stromschienen, insbesondere drei Stromschienen, auf, wobei der Kühlkörper eine Vielzahl von geschlossenen Bahnen von Ausnehmungen aufweist, wobei die Anzahl der Bahnen von Ausnehmungen der Anzahl der Stromschienen entspricht. In diesem Fall kann ein dreiphasiges System von Stromschienen, beispielsweise zur Verbindung mit einem Stromrichter, durch einen Kühlkörper gekühlt werden. Durch deren Befestigung am Kühlkörper kann neben der Entwärmung auch der zur elektrischen Isolierung notwendige Abstand zwischen den Stromschienen durch die Befestigung der Stromscheinen an dem Kühlkörper sichergestellt werden. Zudem vereinfacht sich die Montage der Stromschienen sowie reduziert sich die Empfindlichkeit gegenüber Beschädigungen bei der Montage durch die Ausnehmungen im Kühlkörper.

Bei einer weiteren vorteilhaften Ausgestaltung der Erfindung ist der Auflagekörper mittels einer Befestigungsvorrichtung bewegungsfrei mit dem Kühlkörper verbunden ist. Durch diese Art von Verbindung wird eine Relativbewegung zwischen dem Kühlkörper und dem Auflagekörper verhindert. Diese Relativbewegung stellt einen Verschleiß und damit einhergehenden Verschlechterung der Kontaktfläche dar. Falls die Flächen direkt miteinander in Berührung sind, kommt es zu einer Aufrauhung der Oberflächen. Bei einer dazwischenliegenden Schicht wie einer Folie, ist diese Schicht einer mechanischen Beanspruchung unterworfen. Durch die bewegungsfreie Verbindung werden Verschleißerscheinungen dauerhaft vermieden und eine zuverlässige und dauerhafte Funktion der Wärmeübertragung bei gleichzeitiger Sicherstellung des elektrischen Isolationsvermögens gewährleistet.

Im Folgenden wird die Erfindung anhand der in den Figuren dargestellten Ausführungsbeispiele näher beschrieben und erläutert. Es zeigen:

FIG 1 ein Kontaktsystem aus dem Stand der Technik,
FIG 2 eine Detailansicht des zuvor genannten Kontaktsystems,
FIG 3, FIG 4 Ausführungsbeispiele eines Kontaktsystems mit vorgeschlagener Ausnehmung und
FIG 5 eine geschlossene Bahn einer Ausnehmung.

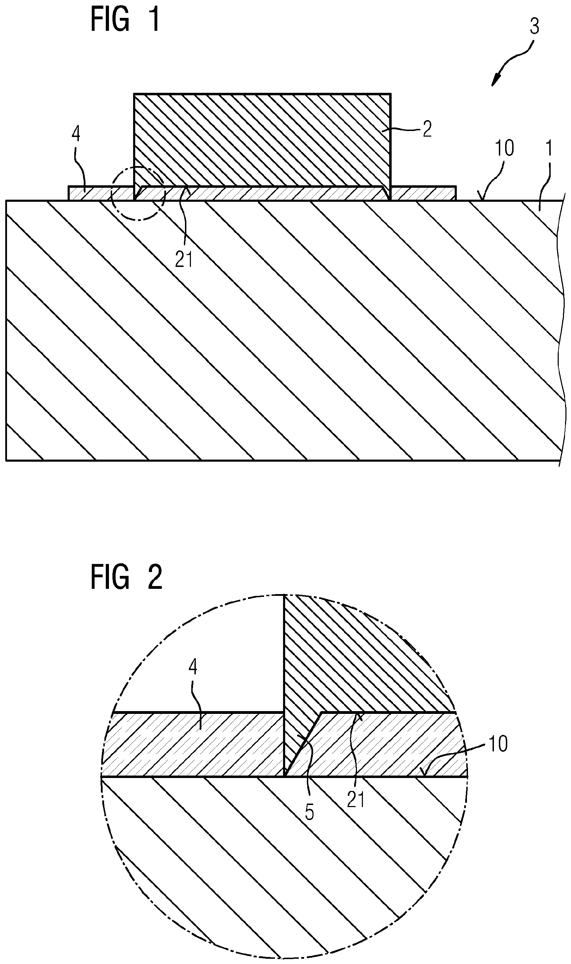

Die FIG 1 zeigt den Querschnitt eines Kontaktsystems 3. Das Kontaktsystemumfasst einen Kühlkörper 1 und einen Auflagekörper 2 mit einer zuverlässigen Isolierung mittels einer Isolierschicht 4. Die Isolierschicht 4 ist zwischen dem Kühlkörper 1 und dem Auflagekörper 2 angeordnet. Der Kühlkörper 1 weist dafür eine erste Oberfläche 10 auf, die für die Kontaktierung mit dem Auflagekörper 2 vorgesehen. Der Auflagekörper 2 weist eine Kontaktfläche 21 auf, die für die Kontaktierung mit der ersten Oberfläche 10 des Kühlkörpers 1 vorgesehen ist.

Der Übersichtlichkeit halber wurde auf Elemente zur Sicherstellung eines dauerhaften Kontaktes zwischen Kühlkörper 1 und Auflagekörper 2 verzichtet. Dies kann beispielsweise durch eine Schraubverbindung, eine Federverbindung, einen Spannverband oder ähnliches realisiert werden. Allgemein kann diese als Befestigungsvorrichtung bezeichnet werden. Der Auflagekörper 2 kann beispielsweise durch ein Halbleitermodul oder eine Stromschiene gebildet werden. Beispielsweise bei einem Kontaktsystem 3 aus Kühlkörper 1 und Stromschiene muss zusätzlich dafür gesorgt werden, dass es aufgrund unterschiedlicher elektrischer Potenziale nicht zu Ausgleichsströmen zwischen Kühlkörper 1 und Auflagekörper 2 kommt. Kühlkörper 1 und Auflagekörper 2 werden daher mittels der Isolierschicht 4 elektrisch voneinander elektrisch isoliert. Dadurch werden unerwünschte Ausgleichsströme zwischen diesen Körpern 1, 2 unterbunden.

Das Kontaktsystem 3 hat somit einen dreischichtigen Aufbau aus dem Kühlkörper 1 mit einem ersten elektrischen Potenzial, einer Isolationsschicht 4 und einem Auflagekörper 2, der ein zweites elektrisches Potenzial führt, wobei sich im allgemeinen das erste und das zweite elektrische Potenzial voneinander unterscheiden. Der Aufbau dieses Ausführungsbeispiels dient beispielsweise der Entwärmung einer Stromschiene über einen Kühlkörper 1. Die Stromschiene bildet dabei den Auflagekörper 2.

Die FIG 2 ist eine Detailansicht des in FIG 1 dargestellten kreisförmigen Bereichs am linken Rand des Auflagekörpers 2. Zur Vermeidung von Wiederholungen wird auf die Beschreibung zur FIG 1 sowie auf die dort eingeführten Bezugszeichen verwiesen. Vom Auflagekörper 2 wird dabei angenommen, dass er einen die reguläre Bauteilgeometrie überragenden geometrischen Fehler, beispielsweise einen Grat 5, aufweist. Dieser Fehler kann die Isolierschicht 4 beim Aufpressen oder Aufdrücken des Auflagekörpers 2 auf den Kühlkörper 1 entweder vollständig durchdringen, was einen elektrischen Kontakt von Kühlkörper 1 und Auflagekörper 2 und damit eine unerwünschte elektrische Verbindung der zu trennenden Potenziale zur Folge hätte. Er kann die Isolierschicht 4 aber auch nur teilweise durchdringen, wodurch der Kontakt, beispielsweise durch Setz- oder Teilentladungseffekte, erst zeitverzögert auftreten kann und in Tests möglicherweise nicht sicher erkannt werden kann.

Besonders kritisch wirkt sich der Fehler aus, wenn die Isolierschicht 4 sehr dünn und/oder weich ist, was beispielsweise bei begrenztem Bauraum oder der Notwendigkeit für einen Wärmedurchgang gegeben ist.

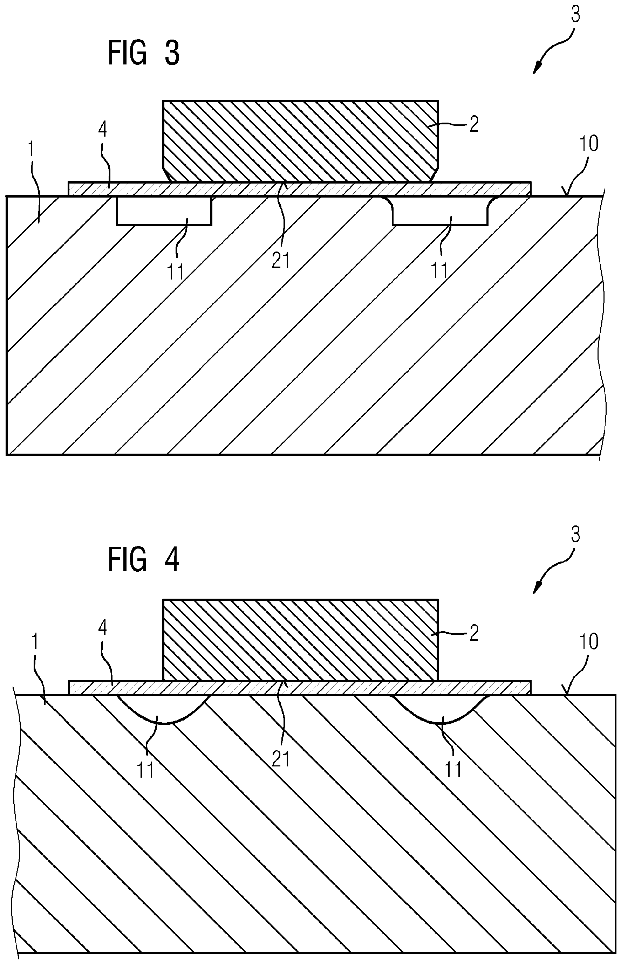

Die FIG 3 zeigt ein Ausführungsbeispiel des vorgeschlagenen Kontaktsystems 3 im Querschnitt. Zur Vermeidung von Wiederholungen wird auf die Beschreibung zu den Figuren 1 und 2 sowie auf die dort eingeführten Bezugszeichen verwiesen. In diesem Ausführungsbeispiel sind im Kühlkörper 1 Ausnehmungen 11 in der ersten Oberfläche 10 eingebracht. Diese wirken vorhandenen geometrischen Fehlern wie beispielsweise einem Grat 5 des Auflagekörpers 1 entgegen.

Der Auflagekörper 2 weist idealerweise gemäß seiner Spezifikation zum Schutz vor Beschädigungen der Isolierschicht 4 gebrochene Kanten auf. Dabei ist in der Darstellung der FIG 3 die rechte Kante des Auflagekörpers 2 am Übergang zur Kontaktfläche 21 als gefaste Kante ausgebildet und die linke Kante des Auflagekörpers 2 am Übergang zur Kontaktfläche 21 als gerundete Kanten ausgebildet. Dies stellt jedoch keinen zuverlässigen Schutz vor überragenden Teilen des Auflagekörpers 2 dar. Die Gefahr der Beschädigung ist damit zwar reduziert, jedoch nicht beseitigt.

Daher wird zur Verbesserung des Kontaktsystems 3 im Hinblick auf eine elektrisch isolierende Kontaktierung vorgeschlagen, eine oder mehrere Ausnehmungen an der ersten Oberfläche 10 des Kühlkörpers 1 vorzusehen. Diese sind in der Lage, überragenden geometrische Fehler, wie beispielsweise einen Grat 5, aufzunehmen, ohne einen Druck auf die dazwischenliegende Isolierschicht 4 auszuüben. Dies bietet einen zuverlässigen Schutz der Isolierschicht 4, indem die Ausnehmungen 11 der Isolierschicht 4 die Möglichkeit geben, sich bei aufliegenden Graten 5 oder anderen hervorstehenden Geometriefehlern in einen Hohlraum der Ausnehmung 11 zurückzuziehen. Die dadurch stark verringerte Kraftwirkung auf die Isolierschicht 4 verhindert ein Verletzen oder gar Durchdringen der Isolierschicht 4 durch den Auflagekörper 2. Der Hohlraum wird durch eine Materialausnehmung, als Ausnehmung 11 bezeichnet, im Kühlkörper 1 gebildet. Diese befindet sich vorteilhafterweise bei einem Kontaktsystem 3 an der Kante der Kontaktfläche 21 des Auflagekörpers 1. Sie kann insbesondere einen rechteckig geformten Querschnitt haben, wie es in der linken Ausnehmung 11 dargestellt ist. Alternativ oder ergänzend ist es auch möglich, die Ausnehmung 11 mit einem gerundeten Querschnitt, insbesondere am Übergang zur ersten Oberfläche 10, auszuführen. Darüber hinaus sind auch andersartig geformte Querschnitte für die Ausnehmung 11 möglich und sinnvoll.

Die Isolierschicht 4 kann den Hohlraum, wie dargestellt, vollständig, alternativ aber auch nur teilweise überdecken.

Darüber hinaus zeigt die FIG 4 den Querschnitt eines weiteren Ausführungsbeispiels mit einem ovalen Querschnitt der Ausnehmung 11. Zur Vermeidung von Wiederholungen wird für die Erläuterung der FIG 4 auf die Beschreibung zu den Figuren 1 bis 3 sowie auf die dort eingeführten Bezugszeichen verwiesen. Vorteilhafterweise verfügt der Kühlkörper 1 über eine gebrochene Kante, insbesondere auf der durch den Auflagekörper 2 überragten Seite. Dies reduziert noch einmal die Belastung auf die Isolierschicht 4. Gerade für den Fall, dass die Isolierschicht 4 die gesamte Ausnehmung 11 überdeckt, hat es sich als vorteilhaft erwiesen, zusätzlich auch auf der gegenüberliegenden Seite der Ausnehmung die Kante als eine gebrochene Kante auszuführen. Die gebrochene Kante verhindert ein Eindringen des Kühlkörpers 1 in die Isolierschicht.

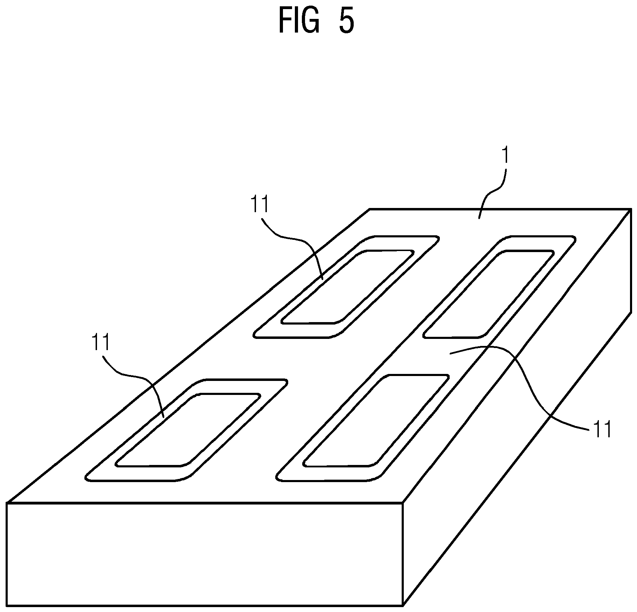

Die FIG 5 zeigt einen weiteren Kühlkörper 1 mit Ausnehmungen 11. Durch die perspektivische Darstellung lassen sich die geschlossenen Bahnen der Ausnehmungen 11 erkennen. Im linken Teil des Kühlkörpers 1 sind zwei separate Ausnehmungen 11 vorhanden, die eine Kontaktierung von zwei Auflagekörpern 2 ermöglichen. Die Auflagekörper 2 haben dabei eine in etwa rechteckförmige Kontaktfläche, die dann bei der Kontaktierung Teile der Ausnehmung 11 überlappt. Im rechten Teil des Kühlkörpers 1 ist eine 8-förmige Ausnehmung dargestellt. Die unterschiedlichen Abschnitte der Ausnehmung können dabei unterschiedliche Breite aufweisen. Insbesondere der mittlere Steg bei der 8-förmigen Ausgestaltung der Ausnehmung 11 kann breiter gewählt werden. Damit wird eine höhere Flexibilität beim Einsatz des Kühlkörpers gewährleistet. Auch bei der 8-förmigen Ausgestaltung der Ausnehmung 11 handelt es sich um eine geschlossene Bahn. An dieser Ausnehmung 11 können beispielsweise zwei Auflagekörper 2 kontaktiert werden. An dem mittleren Steg der Ausnehmung 11 nutzen dann beide Auflagekörper 2 die Ausnehmung. Alternativ ist es auch möglich, jeweils einen großen Auflagekörper 2 zu kontaktieren, der nur den außen liegenden Teil der Ausnehmung 11 nutzt. Diese Art von Ausnehmung 11 ist besonders flexibel, da unterschiedliche Ausgestaltungen der Auflagekörper 2 mit dem Kühlkörper 1 unter Ausnutzung der genannten Vorteile verbunden werden können.

**Patentansprüche**

1. Kontaktsystem (3) aufweisend

   - einen Kühlkörper (1) zur elektrisch isolierten und/oder wärmeleitenden Kontaktierung mit einem Auflagekörper (2) und
   - einen Auflagekörper (2),
   wobei der Kühlkörper (1) eine erste Oberfläche (10) aufweist, wobei die erste Oberfläche (10) mindestens eine Ausnehmung (11) aufweist, wobei die Ausnehmung (11) in einem Bereich der ersten Oberfläche (10) angeordnet ist, der für die Kontaktierung mit dem Rand einer Kontaktfläche (21) des Auflagekörpers (2) vorgesehen ist, wobei die Ausnehmung (11) eine geschlossene Bahn auf der ersten Oberfläche (10) des Kühlkörpers (1) bildet, wobei die erste Oberfläche (10) im Wesentlichen als ebene Fläche ausgeführt ist,
   wobei eine Kontaktfläche (21) des Auflagekörpers (2) derart an dem Kühlkörper (1) angeordnet ist, dass die Ausnehmung (11) des Kühlkörpers (1) sich vollständig entlang des Randes der Kontaktfläche (21) erstreckt, wobei zwischen dem Kühlkörper (1) und dem Auflagekörper (2) eine elektrisch isolierende Schicht (4) angeordnet ist, **dadurch gekennzeichnet, dass** die isolierende Schicht (4) die Ausnehmung (11) derart bedeckt, dass sich aus Ausnehmung (11) und isolierender Schicht (4) ein geschlossener Kanal ergibt.

2. Kontaktsystem (3) nach Anspruch 1, wobei der Kühlkörper (1) eine Vielzahl von geschlossenen Bahnen von Ausnehmungen (11) aufweist.

3. Kontaktsystem (3) nach einem der Ansprüche 1 oder 2, wobei der Querschnitt der Ausnehmung (11) des Kühlkörpers (1) rechteckförmig oder gerundet ausgeführt ist.

4. Kontaktsystem (3) nach einem der Ansprüche 1 bis 3, wobei der Übergang zwischen der Ausnehmung (11) und dem ebenen Teil der ersten Oberfläche (10) gebrochen ausgebildet ist.

5. Kontaktsystem (3) nach einem der Ansprüche 1 bis 4, wobei die elektrisch isolierende Schicht (4) wärmeleitfähig ist.

6. Kontaktsystem (3) nach einem der Ansprüche 1 bis 5, wobei die elektrisch isolierende Schicht (4) durch eine Folie gebildet wird.

7. Kontaktsystem (3) nach einem der Ansprüche 1 bis 6, wobei in der Ausnehmung (11) ein gelartiges Material angeordnet ist.

8. Kontaktsystem (3) nach einem der Ansprüche 1 bis 7, wobei der Auflagekörper (2) durch eine Stromschiene gebildet wird.

9. Kontaktsystem (3) nach Anspruch 8, wobei das Kontaktsystem (3) eine Vielzahl von Stromschienen, insbesondere drei Stromschienen, aufweist, wobei der Kühlkörper (1) eine Vielzahl von geschlossenen Bahnen von Ausnehmungen (11) aufweist, wobei die Anzahl der Bahnen von Ausnehmungen der Anzahl der Stromschienen entspricht.

10. Kontaktsystem (3) nach einem der Ansprüche 1 bis 9, wobei der Auflagekörper (2) mittels einer Befestigungsvorrichtung bewegungsfrei mit dem Kühlkörper verbunden ist.

11. Verfahren zur Herstellung eines Kontaktsystems (3) nach einem der Ansprüche 1 bis 10, wobei die isolierende Schicht (4) auf dem Kühlkörper derart angeordnet wird, **dadurch gekennzeichnet, dass** die isolierende Schicht (4) die Ausnehmung (11) derart bedeckt, dass sich aus Ausnehmung (11) und isolierender Schicht (4) ein geschlossener Kanal ergibt, wobei der Auflagekörper (2) derart auf dem Kühlkörper (1) platziert wird, dass die elektrisch isolierende Schicht (4) zwischen dem Kühlkörper (1) und dem Auflagekörper (2) angeordnet ist und dass der gesamte Rand der Kontaktfläche (21) des Auflagekörpers (2) sich entlang der Ausnehmung (11) des Kühlkörpers (1) erstreckt.

**Claims**

1. Contact system (3) having

   - a heat sink (1) for contacting with a support body (2) in an electrically insulated and/or heat-conducting manner, and
   - a support body (2),
   wherein the heat sink (1) has a first surface (10), wherein the first surface (10) has at least one recess (11), wherein the recess (11) is located in a region of the first surface (10), which region is intended for contacting with the periphery of a contact area (21) of the support body (2), wherein the recess (11) forms an unbroken track on the first surface (10) of the heat sink (1), wherein the first surface (10) is embodied substantially as a flat area,
   wherein a contact area (21) of the support body (2) is located on the heat sink (1) in such a way that the recess (11) of the heat sink (1) extends completely along the periphery of the contact area (21), wherein an electrically insulating layer (4) is arranged between the heat sink (1) and the support body (2), **characterised in that** the insulating layer (4) covers the recess (11) in such a way that a closed channel is formed by recess (11) and insulating layer (4).

2. Contact system (3) according to claim 1, wherein the heat sink (1) has multiple unbroken tracks of recesses (11).

3. Contact system (3) according to one of claims 1 or 2, wherein the cross section of the recess (11) of the heat sink (1) is rectangular or rounded.

4. Contact system (3) according to one of claims 1 to 3, wherein the transition zone between the recess (11) and the flat part of the first surface (10) is chamfered.

5. Contact system (3) according to one of claims 1 to 4, wherein the electrically insulating layer (4) is thermally conductive.

6. Contact system (3) according to one of claims 1 to 5, wherein the electrically insulating layer (4) is formed by a film.

7. Contact system (3) according to one of claims 1 to 6, wherein a gel-type material is arranged in the recess (11).

8. Contact system (3) according to one of claims 1 to 7, wherein the support body (2) is formed by a current bar.

9. Contact system (3) according to claim 8, wherein the contact system (3) has multiple current bars, in particular three current bars, wherein the heat sink (1) has multiple unbroken tracks of recesses (11), wherein the number of tracks of recesses corresponds to the number of current bars.

10. Contact system (3) according to one of claims 1 to 9, wherein the support body (2) is connected to the heat sink by means of a fastening device in a manner which does not allow movement.

11. Method for producing a contact system (3) according to one of claims 1 to 10, wherein the support body (2) is arranged on the heat sink (1) in such a way, **characterised in that** the insulating layer (4) covers the recess (11) in such a way that a closed channel is formed by recess (11) and insulating layer (4), wherein the support body (2) is positioned on the heat sink (1) in such a way that the electrically insulating layer (4) is arranged between the heat sink (1) and the support body (2) and the entire periphery of the contact area (21) of the support body (2) extends along the recess (11) of the heat sink (1).

**Revendications**

1. Système (3) de contact comportant

   - un puits (1) de chaleur pour la mise en contact isolée électriquement et/ou conductrice de la chaleur avec un corps (2) d'appui et
   - un corps (2) d'appui,
   dans lequel le puits (1) de chaleur a une première surface (10), dans lequel la première surface (10) a au moins un évidement (11), dans lequel l'évidement (11) est disposé dans une partie de la première surface (10), qui est prévue pour la mise en contact avec le bord d'une surface (21) de contact du corps (2) d'appui, dans lequel l'évidement (11) forme une piste fermée sur la première surface (10) du puits (1) de chaleur, dans lequel la première surface (10) est réalisée sensiblement sous la forme d'une surface plane, dans lequel une surface (21) de contact du corps (2) d'appui est disposée sur le puits (1) de chaleur, de manière à ce que l'évidement (11) du puits (1) de chaleur s'étende entièrement le long du bord de la surface (21) de contact, dans lequel une couche (4) isolante électriquement est disposée entre le puits (1) de chaleur et le corps (2) d'appui, **caractérisé en ce que** la couche (4) isolante recouvre l'évidement (11), de manière à obtenir, à partir de l'évidement (11) et de la couche (4) isolante, un conduit fermé.

2. Système (3) de contact suivant la revendication 1, dans lequel le puits (1) de chaleur a une pluralité de pistes fermées d'évidements (11).

3. Système (3) de contact suivant l'une des revendications 1 ou 2, dans lequel la section transversale de l'évidement (11) du puits (1) de chaleur est rectangulaire ou arrondie.

4. Système (3) de contact suivant l'une des revendications 1 à 3, dans lequel la transition entre l'évidement (11) et la partie plane de la première surface (10) est interrompue.

5. Système (3) de contact suivant l'une des revendications 1 à 4, dans lequel la couche (4) isolante électriquement est conductrice de la chaleur.

6. Système (3) de contact suivant l'une des revendications 1 à 5, dans lequel la couche (4) isolante électriquement est formée par une feuille.

7. Système (3) de contact suivant l'une des revendications 1 à 6, dans lequel un matériau de type gel est disposé dans l'évidement (11).

8. Système (3) de contact suivant l'une des revendications 1 à 7, dans lequel le corps (2) d'appui est formé par une barre de courant.

9. Système (3) de contact suivant la revendication 8, dans lequel le système (3) de contact a une pluralité de barres de courant, en ayant en particulier trois barres de courant, dans lequel le puits (1) de chaleur a une pluralité de pistes fermées d'évidements (11), dans lequel le nombre des pistes d'évidements correspond au nombre des barres de courant.

10. Système (3) de contact suivant l'une des revendications 1 à 9, dans lequel le corps (2) d'appui est relié au puits de chaleur sans déplacement, au moyen d'un dispositif de fixation.

11. Procédé de fabrication d'un système (3) de contact suivant l'une des revendications 1 à 10, dans lequel on met la couche (4) isolante sur le puits de chaleur, **caractérisé en ce que** la couche (4) isolante recouvre l'évidement (11), de manière à obtenir un conduit fermé à partir de l'évidement (11) et de la couche (4) isolante, dans lequel on place le corps (2) d'appui sur le puits (1) de chaleur, de manière à mettre la couche (4) isolante électriquement entre le puits (1) de chaleur et le corps (2) d'appui et de manière à ce que tout le bord de la surface (21) de contact du corps (2) d'appui s'étende le long de l'évidement (11) du puits (1) de chaleur.

## FIG 1

## FIG 2

FIG 3

FIG 4

# FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2019027421 A1